# EUROPEAN PATENT SPECIFICATION

(11) **EP 4 382 940 B1**
(45) Date of publication and mention of the grant of the patent: **29.07.2026**
(21) Application number: 22938740.2
(22) Date of filing: 28.11.2022
(51) Int. Cl.: G01R 31/40, G01R 31/42, H02J 3/01, H02J 3/38, H02J 3/48, H02J 3/50

(54) **AUXILIARY POWER SUPPLY MODULE CHECKING METHOD AND APPARATUS**
VERFAHREN UND VORRICHTUNG ZUR ÜBERPRÜFUNG EINES HILFSSTROMVERSORGUNGSMODULS
PROCÉDÉ ET APPAREIL DE VÉRIFICATION DE MODULE D'ALIMENTATION ÉLECTRIQUE AUXILIAIRE

(30) Priority: 28.10.2022 CN 202211335952
(43) Date of publication of application: 12.06.2024
(73) Proprietor: CRRC Changchun Railway Vehicles Co., Ltd., Changchun, Jilin 130000 (CN)
(72) Inventor: LIU, Jing, Changchun, Jilin 130000 (CN); SUN, Shijie, Changchun, Jilin 130000 (CN); QUE, Guangxu, Changchun, Jilin 130000 (CN); LIU, Fangming, Changchun, Jilin 130000 (CN)
(74) Representative: Lorenz Seidler Gossel Part. mbB
(86) International application number: PCT/CN2022/134680
(87) International publication number: WO 2024/087303

(56) References cited:
- CN-A- 106 841 874
- CN-A- 106 872 818
- CN-A- 110 967 589
- CN-A- 114 509 628
- CN-A- 115 097 348
- CN-A- 115 097 348
- JP-A- 2020 503 831
- JP-A- 2020 503 831
- US-A1- 2016 282 396

## Description

This application claims the priority to Chinese Patent Application No. 202211335952.X, titled "METHOD AND APPARATUS FOR VERIFYING AUXILIARY POWER SUPPLY MODULE", filed on October 28, 2022 with the China National Intellectual Property Administration.

### FIELD

The present disclosure relates to the technical field of power supply, and in particular to a method and apparatus for verifying an auxiliary power supply module.

### BACKGROUND

A multiple-unit train is normally provided with multiple medium-frequency auxiliary power supply modules for supplying power to medium-voltage loads in the multiple-unit train.

A common medium-voltage power supply mode for the multiple-unit train is grid-connected power supply. In the grid-connected power supply mode, a medium-voltage bus is arranged through the entire multiple-unit train, all medium-frequency auxiliary power supply modules simultaneously output electrical energy to the medium-voltage bus, and all the loads requiring a medium-voltage power supply in the multiple-unit train are directly powered through the medium-voltage bus.

Currently, in the grid-connected power supply mode, in order to ensure reliable power supply and reduce the occurrence of a short circuit or a fault in the medium-voltage bus caused by a difference in alternating-current power outputted by the medium-frequency auxiliary power supply modules, the medium-frequency auxiliary power supply modules connected to the medium-voltage bus are generally products of a same model from a same manufacturer. However, an increasing demand for hybrid grid-connected power supply with medium-frequency auxiliary power supply modules produced by different manufacturers is resulted from various reasons such as the transportation industry and the production demand for the multiple-unit train. Therefore, how to ensure that the medium-frequency auxiliary power supply modules produced by different manufacturers can be used for hybrid grid-connected power supply is a technical problem for those skilled in the art. Document CN115097348 discloses universal testing device for multi-channel redundant power supply module of diesel locomotive. It has an industrial control computer that receives measuring instruments and sends test signal to signal conditioning module to test power supply module.

### SUMMARY

A method and apparatus for verifying an auxiliary power supply module are provided according to the present disclosure, to ensure that auxiliary power supply modules produced by different manufacturers can be used for hybrid grid-connected power supply.

In an aspect, a method for verifying an auxiliary power supply module is provided according to the present disclosure. The method includes:
determining multiple medium-frequency auxiliary power supply modules for grid-connected power supply, where the multiple medium-frequency auxiliary power supply modules have a same rated capacity, and multiple specified output indexes each having rated values that are the same across all the multiple medium-frequency auxiliary power supply modules;
for each of the multiple medium-frequency auxiliary power supply modules, connecting the medium-frequency auxiliary power supply module to a simulated medium-voltage bus, and testing, based on the rated capacity, the medium-frequency auxiliary power supply module in no-load operation, half-load operation and full-load operation in each of the cases where an input voltage of the medium-frequency auxiliary power supply module is controlled to be a preset rated input voltage, a maximum input voltage, and a minimum input voltage, to obtain multiple groups of first test results corresponding to the medium-frequency auxiliary power supply module, where each of the first test results includes a first active power, a first reactive power, a first apparent power, and first test values of the multiple specified output indexes;
connecting the multiple medium-frequency auxiliary power supply modules in parallel to the simulated medium-voltage bus, and testing, based on the rated capacity, the multiple medium-frequency auxiliary power supply modules in no-load operation, half-load operation and full-load operation in each of the cases where input voltages of the multiple medium-frequency auxiliary power supply modules are controlled to be the preset rated input voltage, the maximum input voltage, and the minimum input voltage, to obtain multiple groups of second test results corresponding to each of the multiple medium-frequency auxiliary power supply modules, where each of the second test results includes a second active power, a second reactive power, a second apparent power, and second test values of the multiple specified output indexes; and
determining that the multiple medium-frequency auxiliary power supply modules are suitable for grid-connected power supply, in a case that the first test results meet a first test requirement, the second test results meet a second test requirement, and the multiple medium-frequency auxiliary power supply modules correspond to a same second reactive power and a same second active power.

Preferably, the multiple specified output indexes include an output voltage and an output frequency.

Preferably, the first test results meet the first test requirement includes: a reference output voltage, determined based on a first control line between reactive powers and reference output voltages, corresponding to the first reactive power in each of the first test results is the first test value of the output voltage in the first test result, and a reference output frequency, determined based on a second control line between active powers and reference output frequencies, corresponding to the first active power in the first test result is the first test value of the output frequency in the first test result; and
the second test results meet the second test requirement includes: a reference output voltage, determined based on the first control line, corresponding to the second reactive power in each of the second test results is the second test value of the output voltage in the second test result, and a reference output frequency, determined based on the second control line, corresponding to the second active power in the second test result is the second test value of the output frequency in the second test result.

Preferably, the multiple specified output indexes further include a total harmonic distortion. The first test results meet the first test requirement further includes: the first test value of the total harmonic distortion in the first test result matches a first theoretical value of the total harmonic distortion corresponding to the first test result, and the first apparent power matches a theoretical value of an apparent power corresponding to the first test result. The second test results meet the second test requirement further includes: the second test value of the total harmonic distortion in the second test result matches a second theoretical value of the total harmonic distortion corresponding to the second test result, and the second apparent power matches a second theoretical value of an apparent power corresponding to the second test result.

Preferably, the multiple medium-frequency auxiliary power supply modules are generated according to a preset standard.

Preferably, the preset standard includes: a rated input voltage of an inverter in the medium-frequency auxiliary power supply module being a preset input voltage, a switching frequency of the inverter in the medium-frequency auxiliary power supply module being a preset switching frequency, and a filter circuit in the medium-frequency auxiliary power supply module being a preset standard filter circuit.

Preferably, the preset standard further includes: a power supply control logic algorithm configured in the medium-frequency auxiliary power supply module being a preset standard power supply control algorithm.

In another aspect, an apparatus for verifying an auxiliary power supply module is provided according to the present disclosure. The apparatus includes:
a power supply module determination unit, configured to determine multiple medium-frequency auxiliary power supply modules for grid-connected power supply, where the multiple medium-frequency auxiliary power supply modules have a same rated capacity, and multiple specified output indexes each having rated values that are the same across all the multiple medium-frequency auxiliary power supply modules;
a first test unit, configured to, for each of the multiple medium-frequency auxiliary power supply modules, connect the medium-frequency auxiliary power supply module to a simulated medium-voltage bus, and test, based on the rated capacity, the medium-frequency auxiliary power supply module in no-load operation, half-load operation and full-load operation in each of the cases where an input voltage of the medium-frequency auxiliary power supply module is controlled to be a preset rated input voltage, a maximum input voltage, and a minimum input voltage, to obtain multiple groups of first test results corresponding to the medium-frequency auxiliary power supply module, where each of the first test results includes a first active power, a first reactive power, a first apparent power, and first test values of the multiple specified output indexes;
a second test unit, configured to connect the multiple medium-frequency auxiliary power supply modules in parallel to the simulated medium-voltage bus, and test, based on the rated capacity, the multiple medium-frequency auxiliary power supply modules in no-load operation, half-load operation and full-load operation in each of the cases where input voltages of the multiple medium-frequency auxiliary power supply modules are controlled to be the preset rated input voltage, the maximum input voltage, and the minimum input voltage, to obtain multiple groups of second test results corresponding to each of the multiple medium-frequency auxiliary power supply modules, where each of the second test results includes a second active power, a second reactive power, a second apparent power, and second test values of the multiple specified output indexes; and
a test verification unit, configured to determine that the multiple medium-frequency auxiliary power supply modules are suitable for grid-connected power supply, in a case that the first test results meet a first test requirement, the second test results meet a second test requirement, and the multiple medium-frequency auxiliary power supply modules correspond to a same second reactive power and a same second active power.

Preferably, the multiple specified output indexes corresponding to the medium-frequency auxiliary power supply module determined by a power supply control module include an output voltage and an output frequency.

Preferably, in determining that the first test results meet the first test requirement, the test verification unit is configured to: determine a reference output voltage corresponding to the first reactive power in each of the first test results as the first test value of the output voltage in the first test result based on a first control line between reactive powers and reference output voltages, and determine a reference output frequency corresponding to the first active power in the first test result as the first test value of the output frequency in the first test result based on a second control line between active powers and reference output frequencies; and
in determining that the second test results meet the second test requirement, the test verification unit is configured to: determine a reference output voltage corresponding to the second reactive power in each of the second test results as the second test value of the output voltage in the second test result based on the first control line, and determine a reference output frequency corresponding to the second active power in the second test result as the second test value of the output frequency in the second test result based on the second control line.

It can be seen from the above descriptions, in the embodiments of the present disclosure, multiple medium-frequency auxiliary power supply modules for grid-connected power supply have a same rated capacity and multiple specified output indexes each having rated values that are the same across all the multiple medium-frequency auxiliary power supply modules. Based on this, in the present disclosure, in a case that each of the medium-frequency auxiliary power supply modules is separately connected to the simulated medium-voltage bus, and in a case that the multiple medium-frequency auxiliary power supply modules are connected in parallel to the simulated medium-voltage bus, the multiple medium-frequency auxiliary power supply modules are tested at different input voltages and different loads. In a case that the test results in the multiple test manners meet respective test requirements, and the medium-frequency auxiliary power supply modules obtain a same reactive power and a same active power in the tests when the multiple medium-frequency auxiliary power supply modules are connected in parallel to the simulated medium-voltage bus, it indicates that the multiple medium-frequency auxiliary power supply modules are suitable for grid-connected power supply. It can be seen that before the multiple medium-frequency auxiliary power supply modules from different manufacturers are put into grid-connected power supply, the multiple medium-frequency auxiliary power supply modules can be tested according to the solutions of the present disclosure. In a case that the multiple medium-frequency auxiliary power supply modules are suitable for grid-connected power supply, the multiple medium-frequency auxiliary power supply modules are put into grid-connected power supply, thereby reducing occurrence of abnormal power supply of the medium-voltage bus caused by directly connecting multiple medium-frequency auxiliary power supply modules from different manufacturers that are not suitable for grid-connected power supply to the medium-voltage bus, so that medium-frequency auxiliary power supply modules from different manufacturers can be used for hybrid grid-connected power supply.

### BRIEF DESCRIPTION OF THE DRAWINGS

In order to illustrate technical solutions in embodiments of the present disclosure more clearly, drawings to be used in the embodiments are introduced simply hereinafter. It is apparent that the drawings described below show only some embodiments of the present disclosure. For those skilled in the art, other drawings may be obtained based on the provided drawings without any creative effort.
Figure 1 is a schematic flow chart of a method for verifying an auxiliary power supply module according to an embodiment of the present disclosure;
Figure 2 is a schematic topology diagram showing grid-connected power supply with multiple medium-frequency auxiliary power supply modules according to an embodiment of the present disclosure;
Figure 3 is a schematic diagram showing an inverter and a filter circuit in a medium-frequency auxiliary power supply module according to an embodiment of the present disclosure;
Figure 4 is a schematic diagram showing a relation between reactive powers and reference output voltages according to an embodiment of the present disclosure;
Figure 5 is a schematic diagram showing a relation between active powers and reference output frequencies according to an embodiment of the present disclosure; and
Figure 6 is a schematic diagram of an apparatus for verifying an auxiliary power supply module according to an embodiment of the present disclosure.

### DETAILED DESCRIPTION OF EMBODIMENTS

The technical solutions in the embodiments of the present disclosure are described clearly and completely in conjunction with the drawings in the embodiments of the present disclosure hereinafter. It is apparent that the embodiments described herein are only some embodiments of the present disclosure, rather than all the embodiments. Based on the embodiments of the present disclosure, all other embodiments obtained by those skilled in the art without any creative effort should fall within the protection scope of the present disclosure.

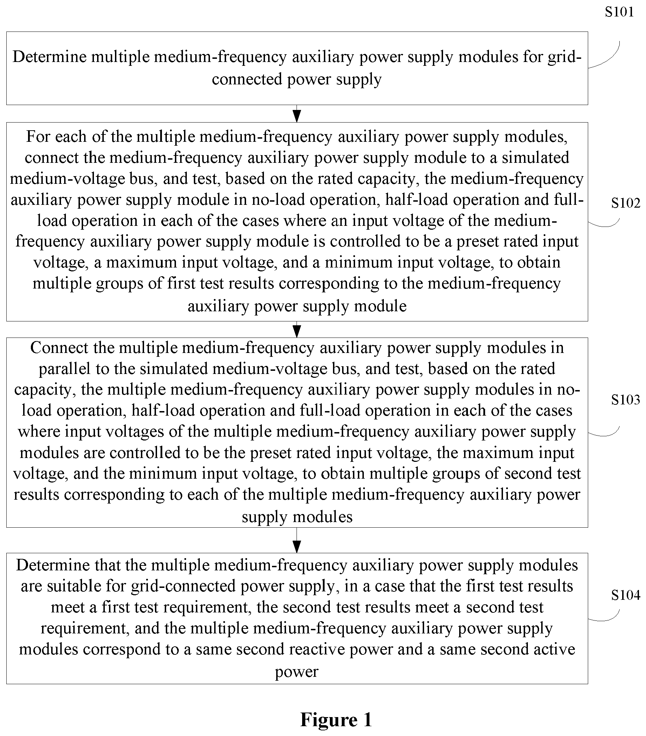

Reference is made to Figure 1, which is a schematic flow chart of a method for verifying an auxiliary power supply module according to an embodiment of the present disclosure. The method according to the embodiment of the present disclosure may include the following steps S101 to S104.

In step S101, multiple medium-frequency auxiliary power supply modules for grid-connected power supply are determined.

The multiple medium-frequency auxiliary power supply modules have a same rated capacity, and multiple specified output indexes each having rated values that are the same across all the multiple medium-frequency auxiliary power supply modules. For example, the rated capacity of each of the medium-frequency auxiliary power supply modules may be 220KVA.

The multiple specified output indexes may include an output voltage and an output frequency. Correspondingly, the multiple medium-frequency auxiliary power supply modules have a same rated output voltage and a same rated output frequency.

The rated output voltage and the rated output frequency each may fluctuate in a range. Therefore, the same rated output voltage and the same rated output frequency each may fluctuate in the range. For example, for each of the medium-frequency auxiliary power supply modules, the rated output voltage of the medium-frequency auxiliary power supply module may be 380V±5%, and the rated output frequency of the medium-frequency auxiliary power supply module may be 50Hz±1Hz.

Furthermore, the multiple specified output indexes may further include a total harmonic distortion (THD). Correspondingly, the multiple medium-frequency auxiliary power supply modules have a same rated value of the total harmonic distortion.

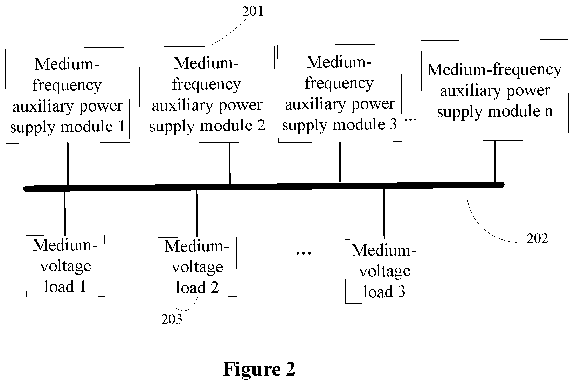

It can be understood that a circuit topology for supplying power to the medium-voltage load in the multiple-unit train in the grid-connected power supply mode may be as shown in Figure 2. In Figure 2, all medium-frequency auxiliary power supply modules 201 are connected in parallel to a medium-voltage bus 202, a medium-voltage load 203 can obtain electrical energy from the medium-voltage bus rather than directly from the medium-frequency auxiliary power supply module. The medium-voltage load is a load device that is supplied with a medium voltage (such as 380V).

It is found in the study that in a case that the medium-voltage bus in the multiple-unit train operates in the grid-connected power supply mode, the medium-frequency auxiliary power supply modules connected to the medium-voltage bus are products of a same model from a same manufacturer, in order to ensure that the medium-frequency auxiliary power supply modules have a same output phase and a same phase sequence; otherwise, a line fault may be caused to the medium-voltage bus.

Based on this, medium-frequency power supply modules produced by different manufacturers output three-phase alternating-current power with a same phase, a same frequency, and a same amplitude to the power supply bus, in order to ensure that the medium-frequency auxiliary power supply modules produced by different manufacturers can be used for hybrid grid-connected power supply.

In order to detect whether the multiple medium-frequency auxiliary power supply modules can output three-phase alternating-current power with the same phase, the same frequency, and the same amplitude to the power supply bus, the medium-frequency auxiliary power supply modules have the same indexes, such as rated capacity, rated output voltage, and rated output frequency. In addition, in order to ensure the reliability, the medium-frequency auxiliary power supply modules are further verified in the following manners according to the embodiment.

Furthermore, in order to ensure that the medium-frequency auxiliary power supply modules produced by different manufacturers can be used for hybrid grid-connected power supply, a preset standard to be met by the different medium-frequency auxiliary power supply modules for hybrid power supply is further determined in the present disclosure. The preset standard may be jointly agreed upon by the multiple-unit train and different manufacturers.

Based on this, in an embodiment, the multiple medium-frequency auxiliary power supply modules in the present disclosure are generated according to the preset standard.

The preset standard may at least specify forms of an inverter and a filter circuit in each of the medium-frequency auxiliary power supply modules. For example, the preset standard may include the following.

A rated input voltage of the inverter in the medium-frequency auxiliary power supply module is a preset input voltage. A switching frequency of the inverter in the medium-frequency auxiliary power supply module is a preset switching frequency. A filter circuit in the medium-frequency auxiliary power supply module is a preset standard filter circuit.

Since the rated input voltage of the inverter in each of the medium-frequency auxiliary power supply modules is the preset input voltage, the inverters in the medium-frequency auxiliary power supply modules have the same rated input voltage.

Since the switching frequency of the inverter in each of the medium-frequency auxiliary power supply modules is the switching frequency, the inverters in the medium-frequency auxiliary power supply modules have the same switching frequency.

The standard filter circuit may be preset. The standard filter circuit includes a circuit formation of the standard filter circuit and parameters of at least some components in the filter circuit. Similarly, in a case that all the filter circuits in the different medium-frequency auxiliary power supply modules are implemented as the standard filter circuit, in different medium-frequency auxiliary power supply modules, the filter circuits have a same structure and a same formation, and parameters of some components in the filter circuits are the same.

For example, in the standard filter circuit, parameters of a capacitor, an inductor, a current sensor, and a voltage sensor may be preset, so that capacitors, inductors, voltage sensors, and current sensors corresponding to respective same positions in different medium-frequency auxiliary power supply modules have respective same parameters.

For example, the parameters of the capacitor and the inductor in the standard filter circuit may be preset according to actual requirements, so that capacitors and inductors corresponding to respective same positions in different medium-frequency auxiliary power supply modules have respective same parameters. The parameters of the current sensor and the voltage sensor are not specifically limited.

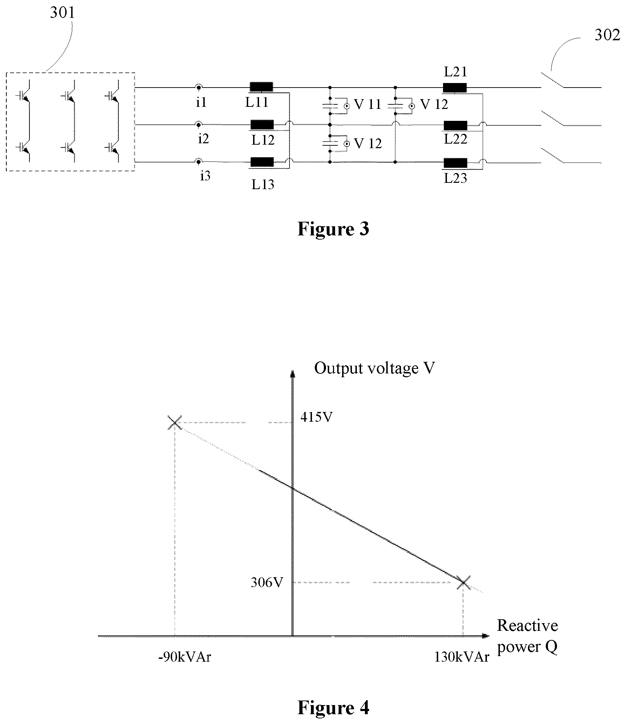

For example, reference is made to Figure 3, which is a schematic structural diagram of a filter circuit in a medium-frequency auxiliary power supply module according to the present disclosure.

In Figure 3, a filter circuit is arranged following an inverter 301.

In Figure 3, the inverter 301 is first connected to three current sensors. The three current sensors are a current sensor il, a current sensor i2, and a current sensor i3 in sequence. The three current sensors are sequentially connected to first filter inductors (for example, a filter inductor L11, a filter inductor L12, and a filter inductor L13 as shown in Figure 3), filter capacitors (for example, the three filter capacitors as shown in Figure 3), voltage sensors (where the three filter capacitors are connected in parallel to a voltage sensor V11, a voltage sensor V12, and a voltage sensor V13, respectively, as shown in Figure 3), and second filter inductors (for example, a filter inductor L21, a filter inductor L22, and a filter inductor L23 as shown in Figure 3). Finally, the filter circuit is connected to the medium-voltage bus through an output contactor 302.

In the present disclosure, in a case that all the filter circuits in the medium-frequency auxiliary power supply modules produced by different manufacturers are implemented as the filter circuit having the circuit structure and formation shown in Figure 3, in the filter circuits in the medium-frequency auxiliary power supply modules produced by different manufacturer, the filter capacitors, the first filter inductors, and the second filter inductors have respective same parameters.

For example, the first filter inductor may be set to 120uH, the filter capacitor may be set to 40uF, and the second filter inductor may be set to 40uH.

It can be understood that the filter circuit in Figure 3 is only an example. In practice, there may be other standard filter circuits. For example, a standard filter circuit is formed by removing the second filter inductor from the filter circuit shown in Figure 3. In addition, the filter circuit may have other formations, which is not limited in the present disclosure.

It can be understood that the medium-frequency auxiliary power supply module may include: a direct-current to direct-current converter, a resonant converter (also known as a high-frequency transformer), an inverter, and a filter circuit. Alternating-current power outputted by the inverter is filtered by the filter circuit, and the filtered alternating-current power is supplied to the medium-voltage bus. Therefore, in a case that the inverters have a same input voltage and a same switching frequency and the filter circuits are the same in the different medium-frequency auxiliary power supply modules, the different medium-frequency auxiliary power supply modules can have same output parameters.

It can be understood that considering that a power supply control logic of the medium-frequency auxiliary power supply module for grid-connected power supply may affect the output parameter of the medium-frequency auxiliary power supply module for a short time period, the preset standard further includes: a power supply control logic algorithm configured in the medium-frequency auxiliary power supply module being a preset standard power supply control algorithm.

The power supply control logic algorithm is mainly used to control a starting process of the medium-frequency auxiliary power supply module when electrical energy is supplied to the medium-frequency auxiliary power supply module. The standard power supply control algorithm may be set as needed, which is not limited herein.

For ease of understanding, the power supply control logic algorithm is explained by an example.

A control process according to the power supply control logic algorithm may be as follows.

In a case that a medium-frequency auxiliary power supply module is the first one, to ever output a voltage, of the multiple medium-frequency auxiliary power supply modules for grid-connected power supply, the medium-frequency auxiliary power supply module may control the inverter to output a voltage from a soft-start voltage to a normal output voltage (such as 380V). In a case that a medium-frequency auxiliary power supply module is not the first one, to ever output a voltage, of the multiple medium-frequency auxiliary power supply modules, that is, the medium-voltage bus has been powered on, the inverter may be controlled so that the voltage outputted by the inverter is same as that of a normal voltage (such as 380V) of the medium-voltage bus, and thereafter is outputted to the medium-voltage bus .

In step S102, for each of the multiple medium-frequency auxiliary power supply modules, the medium-frequency auxiliary power supply module is connected to a simulated medium-voltage bus, and is tested, based on the rated capacity, in no-load operation, half-load operation and full-load operation, in each of the cases where an input voltage of the medium-frequency auxiliary power supply module is controlled to be a preset rated input voltage, a maximum input voltage, and a minimum input voltage, to obtain multiple groups of first test results corresponding to the medium-frequency auxiliary power supply module.

In the present disclosure, the grid-connected power supply tests are not performed on site in a multiple-unit train. Therefore, the simulated medium-voltage bus for simulating the medium-voltage bus in the multiple-unit train it constructed.

The medium-frequency auxiliary power supply module may be connected to the simulated medium-voltage bus by a computer device or manually, after a user finishes setup of the wirings.

The preset rated input voltage herein may be considered as a rated input voltage of the medium-frequency auxiliary power supply module or the rated input voltage of the inverter in the medium-frequency auxiliary power supply module. The maximum input voltage and the minimum input voltage are preset maximum voltage and minimum voltage for testing the medium-frequency auxiliary power supply module. In general, a maximum input voltage and a minimum input voltage that each of the medium-frequency auxiliary power supply modules can withstand may be determined as the maximum input voltage and the minimum input voltage, respectively.

It can be understood that in the present disclosure, the multiple medium-frequency auxiliary power supply modules have the same output phase, the same output frequency, and the same amplitude, to ensure that the multiple medium-frequency auxiliary power supply modules can be used for grid-connected power supply. Therefore, the requirements on rated input voltages of the multiple medium-frequency auxiliary power supply modules may be the same. Based on this, in this step, all the multiple medium-frequency auxiliary power supply modules are tested by using the same rated input voltage, the same maximum input voltage and the same minimum input voltage.

In no-load operation, no load is connected to the simulated medium-voltage bus; in half-load operation, a power value of medium-voltage loads powered by the simulated medium-voltage bus is half of the rated capacity of the medium-frequency auxiliary power supply module, so that a powered load of the medium-frequency auxiliary power supply module is half of the rated capacity; in full-load operation, the power value of the medium-voltage loads powered by the simulated medium-voltage bus is the rated capacity of the medium-frequency auxiliary power supply module.

It can be understood that different test results may be obtained corresponding to different input voltages and different loads. Therefore, the step is performed under nine test conditions, to obtain nine test results. The nine test conditions are: rated input voltage in no-load operation, rated input voltage in half-load operation, rated input voltage in full-load operation, maximum input voltage in no-load operation, maximum input voltage in half-load operation, maximum input voltage in full-load operation, minimum input voltage in no-load operation, minimum input voltage in half-load operation, and minimum input voltage in full-load operation.

For ease of description, in step S102, a test result obtained by testing the single medium-frequency auxiliary power supply module is referred to as the first test result. Correspondingly, nine first test results may be obtained under the above nine test conditions.

Each of the first test results includes a first active power, a first reactive power, a first apparent power, and first test values of the multiple specified output indexes.

For example, the specified output indexes include an output voltage, an output frequency, and a total harmonic distortion. The first test result includes a first test value of the output voltage, a first test value of the output frequency, and a first test value of the total harmonic distortion.

In step S103, the multiple medium-frequency auxiliary power supply modules are connected in parallel to the simulated medium-voltage bus, and are tested, based on the rated capacity, in no-load operation, half-load operation and full-load operation in each of the cases where input voltages of the multiple medium-frequency auxiliary power supply modules are controlled to be the preset rated input voltage, the maximum input voltage, and the minimum input voltage, to obtain multiple groups of second test results corresponding to each of the multiple medium-frequency auxiliary power supply modules.

The step S103 actually simulates the output indexes and related parameters of the multiple medium-frequency auxiliary power supply modules in a case that the multiple medium-frequency auxiliary power supply modules are put into grid-connected power supply.

The preset rated input voltage, the maximum input voltage, and the minimum input voltage are the same as those in the step S102, respectively. Similarly, the meanings of no-load, half-load, and full-load operations are the same as those in the previous steps, which are not repeated herein.

In step S103, there are also actually nine test conditions, which are the same as those in the previous step, except that this step is performed with the multiple medium-frequency auxiliary power supply modules connected in parallel to the simulated medium-voltage bus. Correspondingly, for each of the medium-frequency auxiliary power supply modules, test results can be obtained under nine test conditions, that is, each of the medium-frequency auxiliary power supply modules corresponds to nine test results. For ease of description, the test results obtained in the step are referred to as the second test results.

Each of the second test results includes a second active power, a second reactive power, a second apparent power, and second test values of the multiple specified output indexes.

For example, the specified output indexes include an output voltage, an output frequency, and a total harmonic distortion. Correspondingly, the second test result includes a second test value of the output voltage, a second test value of the output frequency, and a second test value of the total harmonic distortion.

It should be noted that any two medium-frequency auxiliary power supply modules may be tested in step S103. Correspondingly, in subsequent step S104, it may be determined whether the two medium-frequency auxiliary power supply modules are suitable for grid-connected power supply, and finally all at least two medium-frequency auxiliary power supply modules feasible for grid-connected power supply can be determined. Alternatively, all the multiple medium-frequency auxiliary power supply modules are connected in parallel to the simulated medium-voltage bus for unified testing, which is not limited herein.

In step S104, in a case that the first test results meet a first test requirement, the second test results meet a second test requirement, and the multiple medium-frequency auxiliary power supply modules correspond to a same second reactive power and a same second active power, it is determined that the multiple medium-frequency auxiliary power supply modules are suitable for grid-connected power supply.

The multiple medium-frequency auxiliary power supply modules have the same second reactive power and the same second active power, so that in a case that the multiple medium-frequency auxiliary power supply modules are put into grid-connected power supply, a reactive power and an active power of the loads connected to the medium-voltage bus can be evenly split by the multiple medium-frequency auxiliary power supply modules.

It can be understood that for each of the medium-frequency auxiliary power supply modules, each of the first test results is obtained under one test condition in a case that the medium-frequency auxiliary power supply module is separately connected to the medium-voltage bus. Therefore, different first test results may meet different first test requirements.

Similarly, different second test results may correspond to different second test requirements.

Based on this, a first test requirement corresponding to a first test result may be a first test requirement to be met under a test condition corresponding to the first test result. The first test requirement may be a preset requirement to be met by various test values in the first test result or between the test values.

Similarly, a second test requirement corresponding to a second test result may be a second test requirement to be met under a test condition corresponding to the second test result. The second test requirement may be a preset requirement to be met by various test values in the first test result or between the test values.

In an embodiment, in order for grid-connected power supply, the medium-frequency auxiliary power supply modules should have the same output voltage, the same output frequency, the same reactive power, and the same active power in a case that the medium-frequency auxiliary power supply modules are connected to the medium-voltage bus (separately or in parallel), and the load connected to the medium-frequency auxiliary power supply modules (or, put it another way, the medium-voltage bus) is fixed. Moreover, there is a fixed relation between the output voltage and the reactive power of the medium-frequency auxiliary power supply module; similarly, there is also a fixed relation between the output frequency and the active power of the medium-frequency auxiliary power supply module.

Based on this, the first test results meet the first test requirement includes:
for each of the first test results, a reference output voltage, determined based on a first control line between reactive powers and reference output voltages, corresponding to the first reactive power in the first test result is the first test value of the output voltage in the first test result, and
a reference output frequency, determined based on a second control line between active powers and reference output frequencies, corresponding to the first active power in the first test result is the first test value of the output frequency in the first test result.

Correspondingly, the second test results meet the second test requirement includes:
a reference output voltage, determined based on the first control line, corresponding to the second reactive power in each of the second test results is the second test value of the output voltage in the second test result, and
a reference output frequency, determined based on the second control line, corresponding to the second active power in the second test result is the second test value of the output frequency in the second test result.

For example, reference is made to Figure 4, which is a schematic diagram of the first control line between reactive powers and reference output voltages.

In Figure 4, a horizontal axis represents a reactive power Q, and a vertical axis represents an output voltage V.

An oblique line in Figure 4 is the first control line. In Figure 4, a relation between reactive powers and output voltages conforms to the first control line. Based on this, the output voltage is fixed if the reactive power is fixed; and, the reactive power is fixed if the output voltage is fixed.

As shown in Figure 4, in a case that the reactive power is 130kVAr, the output voltage is 360V. In a case that the reactive power is -90kVAr, the output voltage is 415V.

Based on Figure 4, it can be seen that in a case that a tested output voltage and a tested reactive power do not conform to the first control line, it indicates that the output voltage or the output power of the medium-frequency auxiliary power supply module is incorrect, and the medium-frequency auxiliary power supply module does not meet the requirement of grid-connected power supply together with other medium-frequency auxiliary power supply modules.

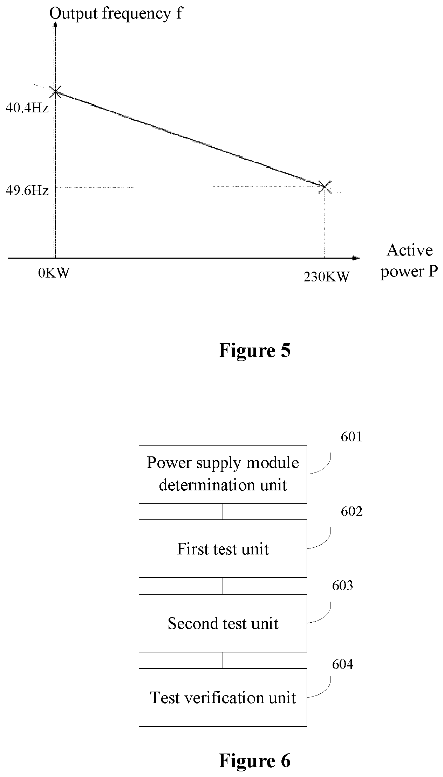

Similarly, Figure 5 is a schematic diagram of the second control line between active powers and output frequencies.

In Figure 5, a horizontal axis represents an active power P, and a vertical axis represents an output power f. An oblique line in Figure 5 represents the second control line.

Based on Figure 5, it can be seen that when multiple medium-frequency auxiliary power supply modules are put into grid-connected power supply, the active power and the output power of any one of the medium-frequency auxiliary power supply modules outputted during the tests conform to the second control line in Figure 5.

As shown in Figure 5, in a case that the active power of the medium-frequency auxiliary power supply module is 230kW, the output frequency of the medium-frequency auxiliary power supply module is 49.6Hz. In a case that the active power is 0, the output frequency is 40.4Hz.

Figures 4 and 5 are only an example of the first control line and the second control line. In practice, the first control line and the second control line may be in other forms.

It can be understood that in the present disclosure, in order to ensure that different medium-frequency auxiliary power supply modules have same outputs under a same test environment and a same test condition, it is further determined whether the test value of each of the indexes in the first test result meets a theoretical value corresponding to this index in the first test result.

For example, in a case that a single medium-frequency auxiliary power supply module is connected to the simulated medium-voltage bus and is in full-load operation, theoretical values of the active power, the reactive power, the apparent power, the output voltage, and the output frequency of the medium-frequency auxiliary power supply module may be obtained by tests in advance, and it is checked whether test values of these parameters are consistent with the theoretical values thereof obtained by the tests.

Specifically, on the basis of analyzing whether the test requirements are met in combination with the control lines above, in the present disclosure, the first test results meet the first test requirement further includes: the first test value of the total harmonic distortion in the first test result matches a first theoretical value of the total harmonic distortion corresponding to the first test result, and the first apparent power matches a theoretical value of an apparent power corresponding to the first test result.

Correspondingly, the second test results meet the second test requirement further includes: the second test value of the total harmonic distortion in the second test result matches a second theoretical value of the total harmonic distortion corresponding to the second test result, and the second apparent power matches a second theoretical value of an apparent power corresponding to the second test result.

In the embodiments of the present disclosure, multiple medium-frequency auxiliary power supply modules for grid-connected power supply have a same rated capacity and multiple specified output indexes each having rated values that are the same across all the multiple medium-frequency auxiliary power supply modules. Based on this, in the present disclosure, in a case that each of the medium-frequency auxiliary power supply modules is separately connected to the simulated medium-voltage bus, and in a case that the multiple medium-frequency auxiliary power supply modules are connected in parallel to the simulated medium-voltage bus, the multiple medium-frequency auxiliary power supply modules are tested at different input voltages and different loads. In a case that the test results in the multiple test manners meet respective test requirements, and the medium-frequency auxiliary power supply modules obtain a same reactive power and a same active power in the tests when the multiple medium-frequency auxiliary power supply modules are connected in parallel to the simulated medium-voltage bus, it indicates that the multiple medium-frequency auxiliary power supply modules are suitable for grid-connected power supply. It can be seen that before the multiple medium-frequency auxiliary power supply modules from different manufacturers are put into grid-connected power supply, the multiple medium-frequency auxiliary power supply modules can be tested according to the solutions of the present disclosure. In a case that the multiple medium-frequency auxiliary power supply modules are suitable for grid-connected power supply, the multiple medium-frequency auxiliary power supply modules are put into grid-connected power supply, thereby reducing occurrence of abnormal power supply of the medium-voltage bus caused by directly connecting multiple medium-frequency auxiliary power supply modules from different manufacturers that are not suitable for grid-connected power supply to the medium-voltage bus, so that medium-frequency auxiliary power supply modules from different manufacturers can be used for hybrid grid-connected power supply.

On the premise that the medium-frequency auxiliary power supply modules are produced by the manufacturers according to the preset standard in the present disclosure, it can be further analyzed whether the multiple medium-frequency auxiliary power supply modules are suitable for grid-connected power supply by testing the multiple medium-frequency auxiliary power supply modules according to the solutions of the present disclosure, which can select multiple medium-frequency auxiliary power supply modules having a same output frequency, a same output phase, and a same output amplitude in the grid-connected power supply mode.

Corresponding to the method for verifying an auxiliary power supply module according to the present disclosure, an apparatus for verifying an auxiliary power supply module is further provided according to the present disclosure.

Reference is made to Figure 6, which is a schematic structural diagram of an apparatus for verifying an auxiliary power supply module according to the present disclosure. The apparatus according to the present disclosure includes a power supply module determination unit 601, a first test unit 602, a second test unit 603 and a test verification unit 604.

The power supply module determination unit 601 is configured to determine multiple medium-frequency auxiliary power supply modules for grid-connected power supply, where the multiple medium-frequency auxiliary power supply modules have a same rated capacity, and multiple specified output indexes each having rated values that are the same across all the multiple medium-frequency auxiliary power supply modules.

The first test unit 602 is configured to, for each of the multiple medium-frequency auxiliary power supply modules, connect the medium-frequency auxiliary power supply module to a simulated medium-voltage bus, and test, based on the rated capacity, the medium-frequency auxiliary power supply module in no-load operation, half-load operation and full-load operation in each of the cases where an input voltage of the medium-frequency auxiliary power supply module is controlled to be a preset rated input voltage, a maximum input voltage, and a minimum input voltage, to obtain multiple groups of first test results corresponding to the medium-frequency auxiliary power supply module, where each of the first test results includes a first active power, a first reactive power, a first apparent power, and first test values of the multiple specified output indexes.

The second test unit 603 is configured to connect the multiple medium-frequency auxiliary power supply modules in parallel to the simulated medium-voltage bus, and test, based on the rated capacity, the multiple medium-frequency auxiliary power supply modules in no-load operation, half-load operation and full-load operation in each of the cases where input voltages of the multiple medium-frequency auxiliary power supply modules are controlled to be the preset rated input voltage, the maximum input voltage, and the minimum input voltage, to obtain multiple groups of second test results corresponding to each of the multiple medium-frequency auxiliary power supply modules, where each of the second test results includes a second active power, a second reactive power, a second apparent power, and second test values of the multiple specified output indexes.

The test verification unit 604 is configured to determine that the multiple medium-frequency auxiliary power supply modules are suitable for grid-connected power supply, in a case that the first test results meet a first test requirement, the second test results meet a second test requirement, and the multiple medium-frequency auxiliary power supply modules correspond to a same second reactive power and a same second active power.

In an embodiment, the multiple specified output indexes corresponding to the medium-frequency auxiliary power supply module determined by a power supply control module include an output voltage and an output frequency.

In an embodiment, in determining that the first test results meet the first test requirement, the test verification unit is configured to: determine a reference output voltage corresponding to the first reactive power in each of the first test results as the first test value of the output voltage in the first test result based on a first control line between reactive powers and reference output voltages, and determine a reference output frequency corresponding to the first active power in the first test result as the first test value of the output frequency in the first test result based on a second control line between active powers and reference output frequencies; and

in determining that the second test results meet the second test requirement, the test verification unit is configured to: determine a reference output voltage corresponding to the second reactive power in each of the second test results as the second test value of the output voltage in the second test result based on the first control line, and determine a reference output frequency corresponding to the second active power in the second test result as the second test value of the output frequency in the second test result based on the second control line.

It should be noted that the embodiments in this specification are described in a progressive manner. Each of the embodiments focuses on differences with other embodiments, and the same or similar parts among the embodiments can be referred to each other. The features in the embodiments in this specification may be replaced or combined with each other, so that those skilled in the art can implement or practice the present disclosure. Since the apparatus disclosed in the embodiments is basically similar to the method therein, the description of the apparatus is relatively simple, and the related parts may refer to the description of the method disclosed in the embodiments.

Finally, it should be further noted that the relationship terms herein such as "first", "second" and the like are only used to distinguish one entity or operation from another, rather than necessitate or imply that any such actual relationship or order exists between these entities or operations. Moreover, the terms "comprise", "include", or any other variants thereof are intended to encompass a non-exclusive inclusion, such that the process, method, article, or device including a series of elements includes not only those elements but also those elements that are not explicitly listed, or the elements that are inherent to such process, method, article, or device. Unless expressively limited otherwise, the statement "comprising (including) one..." does not exclude the case that additional similar elements included in the process, method, article or device that includes the elements.

## Claims

1. A method for verifying an auxiliary power supply module(201), comprising:
determining a plurality of medium-frequency auxiliary power supply modules for grid-connected power supply, wherein the plurality of medium-frequency auxiliary power supply modules have a same rated capacity, and a plurality of specified output indexes each having rated values that are the same across all the plurality of medium-frequency auxiliary power supply modules;
for each of the plurality of medium-frequency auxiliary power supply modules, connecting the medium-frequency auxiliary power supply module to a simulated medium-voltage bus, and testing, based on the rated capacity, the medium-frequency auxiliary power supply module in no-load operation, half-load operation and full-load operation in each of the cases where an input voltage of the medium-frequency auxiliary power supply module is controlled to be a preset rated input voltage, a maximum input voltage, and a minimum input voltage, to obtain a plurality of groups of first test results corresponding to the medium-frequency auxiliary power supply module, wherein each of the first test results comprises a first active power, a first reactive power, a first apparent power, and first test values of the plurality of specified output indexes;
**characterised by**:
connecting the plurality of medium-frequency auxiliary power supply modules in parallel to the simulated medium-voltage bus, and testing, based on the rated capacity, the plurality of medium-frequency auxiliary power supply modules in no-load operation, half-load operation and full-load operation in each of the cases where input voltages of the plurality of medium-frequency auxiliary power supply modules are controlled to be the preset rated input voltage, the maximum input voltage, and the minimum input voltage, to obtain a plurality of groups of second test results corresponding to each of the plurality of medium-frequency auxiliary power supply modules, wherein each of the second test results comprises a second active power, a second reactive power, a second apparent power, and second test values of the plurality of specified output indexes; and
determining that the plurality of medium-frequency auxiliary power supply modules are suitable for grid-connected power supply, in a case that the first test results meet a first test requirement, the second test results meet a second test requirement, and the plurality of medium-frequency auxiliary power supply modules correspond to a same second reactive power and a same second active power.

2. The method according to claim 1, wherein the plurality of specified output indexes comprise an output voltage and an output frequency.

3. The method according to claim 2, wherein the first test results meet the first test requirement comprises: a reference output voltage, determined based on a first control line between reactive powers and reference output voltages, corresponding to the first reactive power in each of the first test results is the first test value of the output voltage in the first test result, and a reference output frequency, determined based on a second control line between active powers and reference output frequencies, corresponding to the first active power in the first test result is the first test value of the output frequency in the first test result; and
the second test results meet the second test requirement comprises: a reference output voltage, determined based on the first control line, corresponding to the second reactive power in each of the second test results is the second test value of the output voltage in the second test result, and a reference output frequency, determined based on the second control line, corresponding to the second active power in the second test result is the second test value of the output frequency in the second test result.

4. The method according to claim 3, wherein the plurality of specified output indexes further comprise a total harmonic distortion,
wherein the first test results meet the first test requirement further comprises: the first test value of the total harmonic distortion in the first test result matches a first theoretical value of the total harmonic distortion corresponding to the first test result, and the first apparent power matches a theoretical value of an apparent power corresponding to the first test result; and
the second test results meet the second test requirement further comprises: the second test value of the total harmonic distortion in the second test result matches a second theoretical value of the total harmonic distortion corresponding to the second test result, and the second apparent power matches a second theoretical value of an apparent power corresponding to the second test result.

5. The method according to claim 1, wherein the plurality of medium-frequency auxiliary power supply modules are generated according to a preset standard.

6. The method according to claim 5, wherein the preset standard comprises:
a rated input voltage of an inverter (301) in the medium-frequency auxiliary power supply module being a preset input voltage;
a switching frequency of the inverter in the medium-frequency auxiliary power supply module being a preset switching frequency; and
a filter circuit in the medium-frequency auxiliary power supply module being a preset standard filter circuit.

7. The method according to claim 6, wherein the preset standard further comprises:
a power supply control logic algorithm configured in the medium-frequency auxiliary power supply module being a preset standard power supply control algorithm.

8. An apparatus for verifying an auxiliary power supply module, comprising:
a power supply module determination unit(601), configured to determine a plurality of medium-frequency auxiliary power supply modules for grid-connected power supply, wherein the plurality of medium-frequency auxiliary power supply modules have a same rated capacity, and a plurality of specified output indexes each having rated values that are the same across all the plurality of medium-frequency auxiliary power supply modules;
a first test unit(602), configured to, for each of the plurality of medium-frequency auxiliary power supply modules, connect the medium-frequency auxiliary power supply module to a simulated medium-voltage bus, and test, based on the rated capacity, the medium-frequency auxiliary power supply module in no-load operation, half-load operation and full-load operation in each of the cases where an input voltage of the medium-frequency auxiliary power supply module is controlled to be a preset rated input voltage, a maximum input voltage, and a minimum input voltage, to obtain a plurality of groups of first test results corresponding to the medium-frequency auxiliary power supply module, wherein each of the first test results comprises a first active power, a first reactive power, a first apparent power, and first test values of the plurality of specified output indexes; **characterised by** further comprising
a second test unit(603) configured to connect the plurality of medium-frequency auxiliary power supply modules in parallel to the simulated medium-voltage bus, and test, based on the rated capacity, the plurality of medium-frequency auxiliary power supply modules in no-load operation, half-load operation and full-load operation in each of the cases where input voltages of the plurality of medium-frequency auxiliary power supply modules are controlled to be the preset rated input voltage, the maximum input voltage, and the minimum input voltage, to obtain a plurality of groups of second test results corresponding to each of the plurality of medium-frequency auxiliary power supply modules, wherein each of the second test results comprises a second active power, a second reactive power, a second apparent power, and second test values of the plurality of specified output indexes; and
a test verification unit(604), configured to determine that the plurality of medium-frequency auxiliary power supply modules are suitable for grid-connected power supply, in a case that the first test results meet a first test requirement, the second test results meet a second test requirement, and the plurality of medium-frequency auxiliary power supply modules correspond to a same second reactive power and a same second active power.

9. The apparatus according to claim 8, wherein the plurality of specified output indexes corresponding to the medium-frequency auxiliary power supply module determined by a power supply control module comprise an output voltage and an output frequency.

10. The apparatus according to claim 8, wherein in determining that the first test results meet the first test requirement, the test verification unit is configured to: determine a reference output voltage corresponding to the first reactive power in each of the first test results as the first test value of the output voltage in the first test result based on a first control line between reactive powers and reference output voltages, and determine a reference output frequency corresponding to the first active power in the first test result as the first test value of the output frequency in the first test result based on a second control line between active powers and reference output frequencies; and
in determining that the second test results meet the second test requirement, the test verification unit is configured to: determine a reference output voltage corresponding to the second reactive power in each of the second test results as the second test value of the output voltage in the second test result based on the first control line, and determine a reference output frequency corresponding to the second active power in the second test result as the second test value of the output frequency in the second test result based on the second control line.

## Patentansprüche

1. Verfahren zur Überprüfung eines Hilfsstromversorgungsmoduls (201), mit den folgenden Schritten:
Bestimmen einer Vielzahl von Hilfsstromversorgungsmodulen mittlerer Frequenz für die netzgekoppelte Stromversorgung, wobei die Vielzahl von Hilfsstromversorgungsmodulen mittlerer Frequenz eine gleiche Nennleistung haben, und einer Vielzahl von vorgegebenen Ausgangsindizes, die jeweils Nennwerte haben, die über die gesamte Vielzahl von Hilfsstromversorgungsmodulen mittlerer Frequenz gleich sind;
für jedes der Vielzahl von Hilfsstromversorgungsmodulen mittlerer Frequenz das Verbinden des Hilfsstromversorgungsmoduls mittlerer Frequenz mit einer simulierten Mittelspannungssammelschiene und Prüfen, anhand der Nennleistung, der Vielzahl von Hilfsstromversorgungsmodulen mittlerer Frequenz im Leerlauf, im Halblastbetrieb und im Volllastbetrieb in jedem der Fälle, in denen Eingangsspannungen der Hilfsstromversorgungsmodule mittlerer Frequenz auf die voreingestellte Nenneingangsspannung, die maximale Eingangsspannung und die minimale Eingangsspannung geregelt werden, um eine Vielzahl von Gruppen erster Testergebnisse zu erhalten, die dem Hilfsstromversorgungsmodul mittlerer Frequenz entsprechen, wobei jedes der ersten Testergebnisse eine erste Wirkleistung, eine erste Blindleistung, eine erste Scheinleistung und erste Testwerte der Vielzahl von vorgegebenen Ausgangsindizes umfasst;
**gekennzeichnet durch**:
Parallelschalten der Vielzahl von Hilfsstromversorgungsmodulen mittlerer Frequenz mit der simulierten Mittelspannungssammelschiene und Prüfen, anhand der Nennleistung, der Vielzahl von Hilfsstromversorgungsmodulen mittlerer Frequenz im Leerlauf, im Halblastbetrieb und im Volllastbetrieb in jedem der Fälle, in denen Eingangsspannungen der Vielzahl von Hilfsstromversorgungsmodulen mittlerer Frequenz so geregelt werden, dass sie der voreingestellten Nenneingangsspannung, der maximalen Eingangsspannung und der minimalen Eingangsspannung entsprechen, um eine Vielzahl von Gruppen zweiter Testergebnisse zu erhalten, die jedem der Vielzahl von Hilfsstromversorgungsmodulen mittlerer Frequenz entsprechen, wobei jedes der zweiten Testergebnisse eine zweite Wirkleistung, eine zweite Blindleistung, eine zweite Scheinleistung und zweite Testwerte der Vielzahl von vorgegebenen Ausgangsindizes umfasst; und
Feststellen, dass die Vielzahl von Hilfsstromversorgungsmodulen mittlerer Frequenz für eine netzgekoppelte Stromversorgung geeignet sind, sofern die ersten Testergebnisse eine erste Testanforderung erfüllen, die zweiten Testergebnisse eine zweite Testanforderung erfüllen und die Vielzahl von Hilfsstromversorgungsmodulen mittlerer Frequenz einer gleichen zweiten Blindleistung und einer gleichen zweiten Wirkleistung entsprechen.

2. Verfahren nach Anspruch 1, wobei die Vielzahl von vorgegebenen Ausgangsindizes eine Ausgangsspannung und eine Ausgangsfrequenz umfassen.

3. Verfahren nach Anspruch 2, wobei die ersten Testergebnisse die erste Testanforderung erfüllen, mit den folgenden Schritten: eine ReferenzAusgangsspannung, die auf der Grundlage einer ersten Steuerleitung zwischen Blindleistungen und Referenz-Ausgangsspannungen ermittelt wird und der ersten Blindleistung in jedem der ersten Testergebnisse entspricht, ist der erste Testwert der Ausgangsspannung im ersten Testergebnis, und eine ReferenzAusgangsfrequenz, die auf der Grundlage einer zweiten Steuerleitung zwischen Wirkleistungen und Referenz-Ausgangsfrequenzen ermittelt wird und der ersten Wirkleistung im ersten Testergebnis entspricht, ist der erste Testwert der Ausgangsfrequenz im ersten Testergebnis; und
die zweiten Testergebnisse erfüllen die zweite Testanforderung und umfassen: eine Referenz-Ausgangsspannung, die auf der Grundlage der ersten Steuerleitung ermittelt wird und der zweiten Blindleistung in jedem der zweiten Testergebnisse entspricht, ist der zweite Testwert der Ausgangsspannung im jeweiligen zweiten Testergebnis, und eine Referenz-Ausgangsfrequenz, die auf der Grundlage der zweiten Steuerleitung ermittelt wird und der zweiten Wirkleistung im zweiten Testergebnis entspricht, ist der zweite Testwert der Ausgangsfrequenz im jeweiligen zweiten Testergebnis.

4. Verfahren nach Anspruch 3, wobei die Vielzahl von vorgegebenen Ausgangsindizes ferner eine harmonische Gesamtverzerrung umfassen,
wobei die ersten Testergebnisse die erste Testanforderung erfüllen, ferner umfassend: der erste Testwert der harmonischen Gesamtverzerrung im ersten Testergebnis stimmt mit einem ersten theoretischen Wert der harmonischen Gesamtverzerrung überein, der dem ersten Testergebnis entspricht, und die erste Scheinleistung stimmt mit einem theoretischen Wert einer Scheinleistung überein, der dem ersten Testergebnis entspricht; und
die zweiten Testergebnisse erfüllen die zweite Testanforderung, ferner umfassend: der im zweiten Testergebnis ermittelte Wert für die harmonische Gesamtverzerrung stimmt mit einem zweiten theoretischen Wert für die harmonische Gesamtverzerrung überein, der dem zweiten Testergebnis entspricht, und die zweite Scheinleistung stimmt mit einem zweiten theoretischen Wert für eine Scheinleistung überein, der dem zweiten Testergebnis entspricht.

5. Verfahren nach Anspruch 1, wobei die Vielzahl von Hilfsstromversorgungsmodulen mittlerer Frequenz gemäß einem voreingestellten Standard erzeugt werden.

6. Verfahren nach Anspruch 5, wobei der voreingestellte Standard Folgendes umfasst:
eine Nenn-Eingangsspannung eines Wechselrichters (301) in dem Hilfsstromversorgungsmodul mittlerer Frequenz, die eine voreingestellte Eingangsspannung darstellt;
eine Schaltfrequenz des Wechselrichters in dem Hilfsstromversorgungsmodul mittlerer Frequenz, die eine voreingestellte Schaltfrequenz darstellt; und
eine Filterschaltung in dem Hilfsstromversorgungsmodul mittlerer Frequenz, bei der es sich um eine voreingestellte Standard-Filterschaltung handelt.

7. Verfahren nach Anspruch 6, wobei der voreingestellte Standard ferner Folgendes umfasst:
einen in dem Hilfsstromversorgungsmodul mittlerer Frequenz konfigurierten Algorithmus zur Steuerung der Stromversorgung, bei dem es sich um einen voreingestellten Standardalgorithmus zur Steuerung der Stromversorgung handelt.

8. Vorrichtung zum Überprüfen eines Hilfsstromversorgungsmoduls, umfassend:
eine Bestimmungseinheit (601) für Stromversorgungsmodule, die dazu ausgebildet ist, eine Vielzahl von Hilfsstromversorgungsmodulen mittlerer Frequenz für die netzgekoppelte Stromversorgung zu bestimmen, wobei die Vielzahl von Hilfsstromversorgungsmodulen mittlerer Frequenz eine gleiche Nennleistung haben und eine Vielzahl von vorgegebenen Ausgangsindizes, deren Nennwerte über die gesamte Vielzahl der Hilfsstromversorgungsmodule mittlerer Frequenz hinweg gleich sind;
eine erste Testeinheit (602), die so ausgelegt ist, dass sie für jedes der Vielzahl von Hilfsstromversorgungsmodulen mittlerer Frequenz das jeweilige Hilfsstromversorgungsmodul mittlerer Frequenz mit einer simulierten Mittelspannungssammelschiene verbindet, und das Hilfsstromversorgungsmodul mittlerer Frequenz auf der Grundlage der Nennleistung im Leerlauf, im Halblastbetrieb und im Volllastbetrieb in jedem der Fälle zu prüfen, in denen eine Eingangsspannung des Hilfsstromversorgungsmoduls mittlerer Frequenz auf eine voreingestellte Nenneingangsspannung, eine maximale Eingangsspannung und eine minimale Eingangsspannung geregelt wird, um eine Vielzahl von Gruppen erster Testergebnisse zu erhalten, die dem Hilfsstromversorgungsmodul mittlerer Frequenz entsprechen, wobei jedes der ersten Testergebnisse eine erste Wirkleistung, eine erste Blindleistung, eine erste Scheinleistung und erste Testwerte der Vielzahl von vorgegebenen Ausgangsindizes umfasst;
**dadurch gekennzeichnet, dass** es ferner eine zweite Testeinheit (603) umfasst, die so ausgelegt ist, dass sie die Vielzahl von Hilfsstromversorgungsmodulen mittlerer Frequenz mit der simulierten Mittelspannungssammelschiene parallelschaltet und auf der Grundlage der Nennleistung die Vielzahl von Hilfsstromversorgungsmodulen mittlerer Frequenz im Leerlauf, im Halblastbetrieb und im Volllastbetrieb in jedem der Fälle testet, in denen die Eingangsspannungen der Vielzahl von Hilfsstromversorgungsmodulen mittlerer Frequenz so geregelt werden, dass sie der voreingestellten Nenneingangsspannung, der maximalen Eingangsspannung und der minimalen Eingangsspannung entsprechen, um eine Vielzahl von Gruppen zweiter Testergebnisse zu erhalten, die jedem der Vielzahl von Hilfsstromversorgungsmodulen mittlerer Frequenz entsprechen, wobei jedes der zweiten Testergebnisse eine zweite Wirkleistung, eine zweite Blindleistung, eine zweite Scheinleistung und zweite Testwerte der Vielzahl von vorgegebenen Ausgangsindizes umfasst; und
eine Testüberprüfungseinheit (604), die so ausgelegt ist, dass sie feststellt, ob die Vielzahl von Hilfsstromversorgungsmodulen mittlerer Frequenz für eine netzgekoppelte Stromversorgung geeignet sind, sofern die ersten Testergebnisse eine erste Testanforderung erfüllen, die zweiten Testergebnisse eine zweite Testanforderung erfüllen und die Vielzahl von Hilfsstromversorgungsmodulen mittlerer Frequenz einer gleichen zweiten Blindleistung und einer gleichen zweiten Wirkleistung entsprechen.

9. Vorrichtung nach Anspruch 8, wobei die Vielzahl von vorgegebenen Ausgansindizes, die dem durch ein Stromversorgungssteuermodul bestimmten Hilfsstromversorgungsmodul mittlerer Frequenz entsprechen, eine Ausgangsspannung und eine Ausgangsfrequenz umfassen.

10. Vorrichtung nach Anspruch 8, wobei bei der Feststellung, dass die ersten Testergebnisse die erste Testanforderung erfüllen, die Testüberprüfungseinheit so konfiguriert ist, dass sie: eine der ersten Blindleistung in jedem der ersten Testergebnisse entsprechende Referenzausgangsspannung als ersten Testwert der Ausgangsspannung im jeweiligen ersten Testergebnis auf der Grundlage einer ersten Steuerleitung zwischen Blindleistungen und Referenzausgangsspannungen ermittelt und eine der ersten Wirkleistung im ersten Testergebnis entsprechende Referenzausgangsfrequenz als ersten Testwert der Ausgangsfrequenz im jeweiligen ersten Testergebnis auf der Grundlage einer zweiten Steuerleitung zwischen Wirkleistungen und Referenzausgangsfrequenzen ermittelt; und
bei der Feststellung, dass die zweiten Testergebnisse die zweite Testanforderung erfüllen, ist die Testüberprüfungseinheit so konfiguriert, dass sie: eine der zweiten Blindleistung in jedem der zweiten Testergebnisse entsprechende Referenzausgangsspannung als zweiten Testwert der Ausgangsspannung im jeweiligen zweiten Testergebnis auf der Grundlage der ersten Steuerleitung ermittelt und eine der zweiten Wirkleistung im zweiten Testergebnis entsprechende Referenzausgangsfrequenz als zweiten Testwert der Ausgangsfrequenz im jeweiligen zweiten Testergebnis auf der Grundlage der zweiten Steuerleitung ermittelt.

## Revendications

1. Procédé de vérification d'un module d'alimentation électrique auxiliaire (201), comprenant :
déterminer une pluralité de modules d'alimentation électrique auxiliaires à moyenne fréquence destinés à une alimentation électrique raccordée au réseau, dans lequel la pluralité de modules d'alimentation électrique auxiliaires à moyenne fréquence présente une même capacité nominale, ainsi qu'une pluralité d'indices de sortie spécifiés dont les valeurs nominales sont identiques pour l'ensemble de la pluralité de modules d'alimentation électrique auxiliaires à moyenne fréquence ;
pour chacun de la pluralité de modules d'alimentation électrique auxiliaires à moyenne fréquence, connecter le module d'alimentation électrique auxiliaire à moyenne fréquence à un bus de moyenne tension simulé, et tester, sur la base de la capacité nominale, le module d'alimentation électrique auxiliaire à moyenne fréquence en fonctionnement à vide, à demi-charge et à pleine charge dans chacun des cas où la tension d'entrée du module d'alimentation électrique auxiliaire à moyenne fréquence est régulée pour correspondre à une tension d'entrée nominale prédéfinie, une tension d'entrée maximale et une tension d'entrée minimale, afin d'obtenir une pluralité de groupes de premiers résultats de test correspondant au module d'alimentation électrique auxiliaire à moyenne fréquence, dans lesquels chacun des premiers résultats de test comprend une première puissance active, une première puissance réactive, une première puissance apparente et des premières valeurs de test de la pluralité d'indices de sortie spécifiés ;
**caractérisé par** :
connecter la pluralité de modules d'alimentation électrique auxiliaires à moyenne fréquence en parallèle au bus de moyenne tension simulé, et tester, sur la base de la capacité nominale, la pluralité de modules d'alimentation électrique auxiliaires à moyenne fréquence en fonctionnement à vide, à demi-charge et à pleine charge, dans chacun des cas où les tensions d'entrée de la pluralité de modules d'alimentation électrique auxiliaires à moyenne fréquence sont régulées pour correspondre à la tension d'entrée nominale prédéfinie, à la tension d'entrée maximale, et la tension d'entrée minimale, afin d'obtenir une pluralité de groupes de deuxièmes résultats de test correspondant à chacun des modules d'alimentation électrique auxiliaires à moyenne fréquence, dans lesquels chacun des deuxièmes résultats de test comprend une deuxième puissance active, une deuxième puissance réactive, une deuxième puissance apparente et des deuxièmes valeurs de test de la pluralité d'indices de sortie spécifiés ; et
déterminer que la pluralité de modules d'alimentation électrique auxiliaires à moyenne fréquence est adaptée à une alimentation électrique raccordée au réseau, dans un cas où les premiers résultats de test satisfont à une première exigence de test, les deuxièmes résultats de test satisfont à une deuxième exigence de test, et la pluralité de modules d'alimentation électrique auxiliaires à moyenne fréquence correspond à une même deuxième puissance réactive et à une même deuxième puissance active.

2. Procédé selon la revendication 1, dans lequel la pluralité d'indices de sortie spécifiés comprend une tension de sortie et une fréquence de sortie.

3. Procédé selon la revendication 2, dans lequel le fait que les premiers résultats de test satisfassent à la première exigence de test comprend : une tension de sortie de référence, déterminée sur la base d'une première ligne de commande entre les puissances réactives et les tensions de sortie de référence, correspondant à la première puissance réactive dans chacun des premiers résultats de test, qui est la première valeur de test de la tension de sortie dans le premier résultat de test, et une fréquence de sortie de référence, déterminée sur la base d'une deuxième ligne de commande entre les puissances actives et les fréquences de sortie de référence, correspondant à la première puissance active dans le premier résultat de test, qui est la première valeur de test de la fréquence de sortie dans le premier résultat de test ; et
le fait que les deuxièmes résultats de test satisfassent à la deuxième exigence de test comprend : une tension de sortie de référence, déterminée sur la base de la première ligne de commande, correspondant à la deuxième puissance réactive dans chacun des deuxièmes résultats de test, qui correspond à la deuxième valeur de test de la tension de sortie dans le deuxième résultat de test, et une fréquence de sortie de référence, déterminée sur la base de la deuxième ligne de commande, correspondant à la deuxième puissance active dans le deuxième résultat de test, qui correspond à la deuxième valeur de test de la fréquence de sortie dans le deuxième résultat de test.

4. Procédé selon la revendication 3, dans lequel la pluralité d'indices de sortie spécifiés comprend en outre une distorsion harmonique totale,
dans lequel les premiers résultats de test satisfont à la première exigence de test, et comprend en outre : la première valeur de test de la distorsion harmonique totale figurant dans le premier résultat de test correspond à une première valeur théorique de la distorsion harmonique totale correspondant au premier résultat de test, et la première puissance apparente correspond à une valeur théorique d'une puissance apparente correspondant au premier résultat de test ; et
les deuxièmes résultats de test satisfont à la deuxième exigence de test, ce qui comprend en outre que : la deuxième valeur de test de la distorsion harmonique totale dans le deuxième résultat de test correspond à une deuxième valeur théorique de la distorsion harmonique totale correspondant au deuxième résultat de test, et la deuxième puissance apparente correspond à une deuxième valeur théorique d'une puissance apparente correspondant au deuxième résultat de test.

5. Procédé selon la revendication 1, dans lequel la pluralité de modules d'alimentation électrique auxiliaires à moyenne fréquence est générée selon une norme prédéfinie.

6. Procédé selon la revendication 5, dans lequel la norme prédéfinie comprend :
une tension d'entrée nominale d'un onduleur (301) dans le module d'alimentation électrique auxiliaire à moyenne fréquence étant une tension d'entrée prédéfinie ;
une fréquence de commutation de l'onduleur dans le module d'alimentation électrique auxiliaire à moyenne fréquence étant une fréquence de commutation prédéfinie ; et
un circuit de filtrage intégré au module d'alimentation électrique auxiliaire à moyenne fréquence, qui est un circuit de filtrage standard prédéfini.

7. Procédé selon la revendication 6, dans lequel la norme prédéfinie comprend en outre : un algorithme logique de commande d'alimentation électrique, configuré dans le module d'alimentation électrique auxiliaire à moyenne fréquence, qui est un algorithme de commande d'alimentation électrique standard prédéfini.

8. Appareil de vérification d'un module d'alimentation électrique auxiliaire, comprenant :
une unité de détermination des modules d'alimentation électrique (601), configurée pour déterminer une pluralité de modules d'alimentation électrique auxiliaires à moyenne fréquence destinés à une alimentation électrique raccordée au réseau, dans laquelle la pluralité de modules d'alimentation électrique auxiliaires à moyenne fréquence présente une même capacité nominale, ainsi qu'une pluralité d'indices de sortie spécifiés dont les valeurs nominales sont identiques pour l'ensemble de la pluralité de modules d'alimentation électrique auxiliaires à moyenne fréquence ;
une première unité de test (602), configurée pour, pour chacun des différents modules d'alimentation électrique auxiliaire à moyenne fréquence, connecter le module d'alimentation électrique auxiliaire à moyenne fréquence à un bus de moyenne tension simulé, et de tester, sur la base de la puissance nominale, le module d'alimentation électrique auxiliaire à moyenne fréquence en fonctionnement à vide, à demi-charge et à pleine charge dans chacun des cas où la tension d'entrée du module d'alimentation électrique auxiliaire à moyenne fréquence est régulée pour correspondre à une tension d'entrée nominale prédéfinie, une tension d'entrée maximale et une tension d'entrée minimale, afin d'obtenir une pluralité de groupes de premiers résultats de test correspondant au module d'alimentation électrique auxiliaire à moyenne fréquence, dans lequel chacun des premiers résultats de test comprend une première puissance active, une première puissance réactive, une première puissance apparente et des premières valeurs de test de la pluralité d'indices de sortie spécifiés ;
**caractérisé par** comprenant en outre une deuxième unité de test (603), configurée pour connecter en parallèle la pluralité de modules d'alimentation électrique auxiliaires à moyenne fréquence au bus de moyenne tension simulé, et pour tester, sur la base de la capacité nominale, la pluralité de modules d'alimentation électrique auxiliaires à moyenne fréquence en fonctionnement à vide, à demi-charge et à pleine charge dans chacun des cas où les tensions d'entrée de la pluralité de modules d'alimentation électrique auxiliaires à moyenne fréquence sont régulées pour correspondre à la tension d'entrée nominale prédéfinie, la tension d'entrée maximale, et la tension d'entrée minimale, afin d'obtenir une pluralité de groupes de deuxièmes résultats de test correspondant à chacun de la pluralité de modules d'alimentation auxiliaires à moyenne fréquence, dans lesquels chacun des deuxièmes résultats de test comprend une deuxième puissance active, une deuxième puissance réactive, une deuxième puissance apparente et des deuxièmes valeurs de test de la pluralité d'indices de sortie spécifiés ; et
une unité de vérification de test (604), configurée pour déterminer que la pluralité de modules d'alimentation électrique auxiliaires à moyenne fréquence est adaptée à une alimentation électrique raccordée au réseau, dans un cas où les premiers résultats de test satisfont à une première exigence de test, les deuxièmes résultats de test satisfont à une deuxième exigence de test, et la pluralité de modules d'alimentation électrique auxiliaires à moyenne fréquence correspond à une même deuxième puissance réactive et à une même deuxième puissance active.

9. Appareil selon la revendication 8, dans lequel la pluralité d'indices de sortie spécifiés correspondant au module d'alimentation électrique auxiliaire à moyenne fréquence, déterminés par un module de commande d'alimentation électrique, comprend une tension de sortie et une fréquence de sortie.

10. Appareil selon la revendication 8, dans lequel, en déterminant que les premiers résultats de test satisfont à la première exigence de test, l'unité de vérification de test est configurée pour : déterminer une tension de sortie de référence correspondant à la première puissance réactive dans chacun des premiers résultats de test en tant que première valeur de test de la tension de sortie dans le premier résultat de test, sur la base d'une première ligne de commande entre les puissances réactives et les tensions de sortie de référence, et déterminer une fréquence de sortie de référence correspondant à la première puissance active dans le premier résultat de test en tant que première valeur de test de la fréquence de sortie dans le premier résultat de test, sur la base d'une deuxième ligne de commande entre les puissances actives et les fréquences de sortie de référence ; et
en déterminant que les deuxièmes résultats de test satisfont à la deuxième exigence de test, l'unité de vérification de test est configurée pour : déterminer une tension de sortie de référence correspondant à la deuxième puissance réactive dans chacun des deuxièmes résultats de test, en tant que deuxième valeur de test de la tension de sortie dans le deuxième résultat de test, sur la base de la première ligne de commande, et déterminer une fréquence de sortie de référence correspondant à la deuxième puissance active dans le deuxième résultat de test, en tant que deuxième valeur de test de la fréquence de sortie dans le deuxième résultat de test, sur la base de la deuxième ligne de commande.
